# EUROPÄISCHE PATENTANMELDUNG

(11) **EP 0 800 214 A1**
(43) Veröffentlichungstag der Anmeldung: **08.10.1997**
(21) Anmeldenummer: 97104416.9
(22) Anmeldetag: 14.03.1997
(51) Int. Cl.: H01L 29/205, H01L 33/00

(54) **Bauelement in stickstoffhaltigem Halbleitermaterial**

(30) Priorität: 02.04.1996 DE 19613265
(71) Anmelder: SIEMENS AKTIENGESELLSCHAFT, 80333 München (DE)
(72) Erfinder: Riechert, Henning, Dr., 85521 Riemerling (DE); Strauss, Uwe, Dr., 93077 Bad Abbach (DE)

(57) **Zusammenfassung**

Bauelement mit einer Nitrid-Heterostruktur aus III-V-Halbleitermaterial, die eine aktive Schicht mit hohem Indiumgehalt und eine indiumhaltige Pufferschicht umfaßt und innerhalb derer die Gitterkonstante im wesentlichen durch die Gitterkonstante dieser Pufferschicht bestimmt ist. Zwischen der aktiven Schicht und angrenzendem Halbleitermaterial befindet sich ein Sprung in der Energiebandlücke. Diese Schichtfolge ist auf ein Substrat (z. B. Saphir oder SiC) oder auf eine Halbleiterschicht (z. B. GaN, AlGaN oder AlN) aus einem Material mit einer wesentlich verschiedenen Gitterkonstante aufgewachsen. Das Bauelement ermöglicht es, eine aktive Schicht mit besonders hohem atomarem Anteil an Indium in der III-Komponente auf einem herkömmlichen Substrat so herzustellen, daß die Versetzungen in der Gitterstruktur der aktiven Schicht in tolerierbaren Grenzen bleiben.

## Beschreibung

Die vorliegende Erfindung betrifft ein Bauelement mit einer stickstoffhaltigen Halbleiterschichtstruktur unter Einbeziehung von InGaN. Derartige Bauelemente können z. B. für Strahlungserzeugung im Bereich sichtbaren Lichtes, insbesondere im blauen und grünen Spektrum, oder für Feldeffekttransistoren, insbesondere HEMT, verwendet werden.

Bei der Herstellung von Heterostrukturen aus den III-V-Nitriden (GaN, AlGaN, InGaN) tritt das Problem einer mangelnden Anpassung der Gitterkonstanten dieser Schicht zum Substrat (Saphir, SiC oder dgl.) auf. Es wird auf das Substrat üblicherweise eine erste Schicht als Pufferschicht aufgebracht, innerhalb derer der größte Teil der wegen der Fehlanpassung der Gitterstrukturen auftretenden Versetzungen in dem Kristallgitter entsteht. Diese Pufferschicht besteht üblicherweise aus GaN, AlGaN oder AlN. Diese Schichten nehmen beim Aufwachsen auf das Substrat nach einer gewissen Dicke ihre eigene, materialspezifische Gitterkonstante an. Beim weiteren Aufwachsen von GaN oder AlGaN mit den dabei verwendeten typischen Aluminiumgehalten treten dann im wesentlichen keine weiteren Versetzungen auf. Das ist bei InGaN nicht der Fall, weil InN eine um 11,4% größere Gitterkonstante hat als GaN. Es ist daher zu erwarten, daß eine InGaN-Schicht mit 20% Indium beim Aufwachsen auf GaN nach einer kritischen Dicke von ca. 5 nm beginnt, Versetzungen zu bilden, die die elektrischen und optischen Eigenschaften des Bauelementes im allgemeinen stark verschlechtern und meist auch das nachfolgende Wachstum der Schichten empfindlich stören. Für die meisten Anwendungen sind noch deutlich größere Dicken und höhere Indiumanteile der InGaN-Schicht erforderlich.

Aufgabe der vorliegenden Erfindung ist es, ein Bauelement mit einer stickstoffhaltigen Schichtstruktur anzugeben, bei der eine für Strahlungserzeugung oder Steuerung von Ladungsträgern vorgesehene aktive Schicht mit erheblichem Indiumanteil vorhanden ist und das auf einem herkömmlichen Substrat oder auf Halbleitermaterial ohne Indiumanteil hergestellt werden kann.

Diese Aufgabe wird mit dem Bauelement mit den Merkmalen des Anspruches 1 gelöst. Weitere Ausgestaltungen ergeben sich aus den abhängigen Ansprüchen.

Das erfindungsgemäßen Bauelement enthält eine Nitrid-Heterostruktur, die eine aktive Schicht, die für Strahlungserzeugung oder zur Steuerung von Ladungsträgern z. B. im Kanal eines MESFET oder HEMT vorgesehen ist, umfaßt. Diese aktive Schicht ist III-V-Halbleitermaterial und enthält in der Komponente aus der Gruppe III des Periodensystems einen atomaren Anteil an In von mindestens 20%. Die Komponente aus der Gruppe V des Periodensystems enthält Stickstoff und ggf. weitere Elemente dieser Gruppe V, wie z. B. Arsen. Das Halbleitermaterial der aktiven Schicht ist z. B. InₓGa₁₋ₓN mit x ≥ 0,2. In der Heterostruktur befindet sich zwischen der aktiven Schicht und einem Substrat eine weitere Schicht aus III-V-Halbleitermaterial, dessen III-Komponente Indium und dessen V-Komponente Stickstoff enthalt. Diese weitere Schicht besitzt nicht notwendig, aber vorzugsweise eine Zusammensetzung, die von der Zusammensetzung der aktiven Schicht verschieden ist, und kann auf einem herkömmlichen Substrat oder einer Halbleiterschicht ohne Indiumanteil (z. B. GaN, AlGaN, AlN oder dgl.) oder mit nur einem geringen Indiumanteil aufgewachsen sein. Die Zusammensetzung dieser weiteren Schicht ist im Hinblick auf eine oder mehrere nachfolgend aufgewachsene Schichten so gewählt, daß jede dieser nachfolgend aufgewachsenen Schichten mindestens bis zu der aktiven Schicht beim Aufwachsen im wesentlichen die Gitterkonstante der weiteren Schicht annimmt. Die weitere Schicht wird daher im folgenden und in den Ansprüchen als Pufferschicht bezeichnet. Diese Pufferschicht kann unmittelbar unter der aktiven Schicht vorhanden sein und die einzige weitere Schicht sein, die In enthält. Es kann zwischen der Pufferschicht und der aktiven Schicht weiteres Halbleitermaterial vorhanden sein, das kein In enthält. Dieses weitere Halbleitermaterial ist aber nur so dick, daß die Gitterkonstante der Pufferschicht auch in diesem Fall bestimmend für die Gitterkonstante der aktiven Schicht ist.

Die Pufferschicht wird mindestens so dick aufgewachsen, daß sie zumindest bei den während des Herstellungsprozesses eingestellten hohen Temperaturen in ihren oberen (zuletzt aufgewachsenen) Schichtanteilen entspannt ( 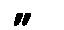 relaxed") ist. In diesem Sinn weist die Pufferschicht die Gitterkonstante auf, die ihrer Zusammensetzung entspricht (eigene materialspezifische Gitterkonstante). Die Nitrid-Heterostruktur kann auch aus einer mehrlagigen oder kontinuierlich in der Zusammensetzung variierten Schichtfolge aus InN oder ternären oder quaternären III-V-Halbleitermaterialien mit Indiumanteil gebildet sein. Die III-Komponente kann in jeder Schicht dieser Schichtfolge einen atomaren Anteil an Indium von mindestens 20% enthalten. Der atomare Anteil an Indium variiert in der Heterostruktur vorzugsweise nur so stark (z. B. um höchstens 20%), daß die aktive Schicht die Gitterkonstante der Pufferschicht annehmen kann, ohne daß erhebliche Versetzungen oder Risse in der Gitterstruktur der aktiven Schicht auftreten, die die Funktionsweise des Bauelementes beeinträchtigen würden. Ein geeignetes Halbleitermaterial für eine solche Schichtstruktur, die außer der aktiven Schicht und der Pufferschicht weitere indiumhaltige Schichten oder Schichtanteile unterschiedlicher Zusammensetzungen aufweist, ist InGaAlN, wobei die Anteile der Elemente aus der Gruppe III (In, Ga, Al) in geeigneter Weise festgelegt werden können. Es können mehrere solcher InGaAlN-Schichten vorhanden sein, die sich durch die Zusammensetzung der Komponente aus der Gruppe III unterscheiden. Es kann die Zusammensetzung zumindest der III-Komponente innerhalb einer Schicht kontinuierlich variieren. Es können auch weitere Elemente aus der Gruppe V, z. B. Arsen, in der Mischkristallzusammensetzung des Halbleitermateriales enthalten sein.

Zwischen der aktiven Schicht und den angrenzenden Schichten ist ein Sprung in der Energiebandlücke vorhanden, was z. B. für ein Confinement der Ladungsträger in der aktiven Schicht gewünscht wird. Eine Änderung der Energiebandlücke innerhalb der Schichtfolge ist z. B. möglich
a) durch örtliche geringe Variation des atomaren Anteiles an Indium,
b) durch Variation der Zusammensetzung der III-Komponente des Halbleitermateriales. Das bedeutet, daß z. B. bei Verwendung von InₓGa_{y}Al_{1-x-y}N die atomaren Anteile x und y von Schicht zu Schicht oder kontinuierlich innerhalb einer Schicht variieren. Das ist möglich, ohne Verspannungen in der Schichtfolge aufzubauen. InGaN und InAlN haben annähernd dieselbe Gitterkonstante; exakt dieselbe Gitterkonstante läßt sich einstellen, indem die Anteile an Indium in den beiden Materialzusammensetzungen geringfügig verschieden gewählt werden. Die wesentliche Änderung der Energiebandlücke läßt sich durch das geänderte Verhältnis der atomaren Anteile von Gallium und Aluminium einstellen.

Ist z. B. ein atomarer Anteil an Indium von 60% in der III-Komponente des Halbleitermateriales der aktiven Schicht erwünscht, kann man z. B. in den angrenzenden Schichten der Nitrid-Heterostruktur einen atomaren Anteil an Indium von 50% in der III-Komponente wählen. Nur beim Übergang zu der aktiven Schicht erhöht sich der Indiumgehalt von 50% auf 60%. Auf diese Weise entstehen je nach Dicke dieser Schicht wesentlich geringere Versetzungen als beim direkten Übergang von GaN auf InGaN mit 60% Indiumgehalt. Die aktive Schicht ist bei diesem Ausführungsbeispiel z. B. In_{0,5}Ga_{0,5}N, die angrenzenden Confinementschichten über und unter der aktiven Schicht sind In_{0,5}Ga_{0,3}Al_{0,2}N.

Bei dem erfindungsgemäßen Bauelement wird die Nitrid-Heterostruktur so gewählt, daß die Gitterkonstante bereits durch die Pufferschicht festgelegt wird und gröbere Versetzungen nur im unteren Schichtanteil der Pufferschicht oder unter der Pufferschicht (falls weitere Schichten mit ähnlicher Gitterkonstante z. B. aus weiterem indiumhaltigem Halbleitermaterial dort vorhanden sind) auftreten. Das kann z. B. dadurch erreicht werden, daß die Zusammensetzungen der Pufferschicht und der aktiven Schicht so gewählt werden, daß die materialspezifische Gitterkonstante der aktiven Schicht bei Zimmertemperatur höchstens um 3 % von der materialspezifischen Gitterkonstante der Pufferschicht bei Zimmertemperatur verschieden ist. Bei einer möglichen und für bestimmte Bauelemente vorteilhaften Ausführungsform ist die materialspezifische Gitterkonstante einer beliebigen indiumhaltigen Schicht der Nitrid-Heterostruktur zwischen dem Substrat und der aktiven Schicht höchstens um 3% größer als die materialspezifische Gitterkonstante einer beliebigen anderen indiumhaltigen Schicht der Nitrid-Heterostruktur zwischen dem Substrat und der aktiven Schicht, jeweils bei Zimmertemperatur. Es kann auf diese Weise eine sehr gute Anpassung der Gitterstrukturen der einzelnen Schichten aneinander vorgenommen werden. Wesentliche Versetzungen entstehen nur in einer Schicht, die von der für die Funktionsweise des Bauelementes wesentlichen aktiven Schicht ausreichend weit entfernt ist. Bei einem erfindungsgemäßen Bauelement, bei dem ein besonders hoher Indiumanteil in der aktiven Schicht erforderlich ist, kann die aktive Schicht und ggf. die gesamte indiumhaltige Schichtfolge der Nitrid-Heterostruktur aus Halbleitermaterial mit einem atomaren Anteil an Indium von mindestens 50% in der III-Komponente bestehen. Auch in diesem Fall kann ein Substrat verwendet werden, das eine von der Gitterkonstante der aktiven Schichten wesentlich abweichende Gitterkonstante besitzt. Es können auf diese Weise Bauelemente hergestellt werden, bei denen die Nitrid-Heterostruktur aufgewachsen ist auf ein Substrat (Saphir oder SiC) oder auf eine Halbleiterschicht (GaN, AlGaN, AlN) mit einer Gitterkonstante, die sich um 2% oder mehr von der Gitterkonstante der aktiven Schicht der Nitrid-Heterostruktur unterscheidet. Das erfindungsgemäße Bauelement bietet daher die Möglichkeit, auf herkömmlichem Material eine Schichtstruktur aufzuwachsen, die eine aktive Schicht umfaßt, deren Mischkristallzusammensetzung eine III-Komponente mit verhältnismäßig hohem atomarem Anteil an In enthält.

## Patentansprüche

1. Bauelement mit einem Substrat und mit einer Nitrid-Heterostruktur,
a) die eine für Strahlungserzeugung oder Steuerung von Ladungsträgern vorgesehene aktive Schicht aus III-V-Halbleitermaterial umfaßt,
b) wobei in dieser aktiven Schicht die Komponente aus der Gruppe III des Periodensystems einen atomaren Anteil an Indium von mindestens 20% enthält und die Komponente aus der Gruppe V des Periodensystems Stickstoff enthält,
c) die zwischen diesem Substrat und dieser aktiven Schicht eine Pufferschicht aus III-V-Halbleitermaterial umfaßt,
d) wobei in dieser Pufferschicht die Komponente aus der Gruppe III des Periodensystems Indium enthält und die Komponente aus der Gruppe V des Periodensystems Stickstoff enthält,
e) bei der die Zusammensetzung des Halbleitermateriales der aktiven Schicht von der Zusammensetzung des Halbleitermateriales, das auf der dem Substrat zugewandten Seite an die aktive Schicht angrenzt, verschieden ist, so daß an der Grenze dieser Halbleitermaterialien eine Änderung der Energiebandlücke auftritt, und
f) bei der die aktive Schicht eine Gitterkonstante aufweist, die bei einer für epitaktisches Wachstum typischen Temperatur der Gitterkonstante der Pufferschicht entspricht.

2. Bauelement nach Anspruch 1,
bei dem in der aktiven Schicht die Komponente aus der Gruppe III des Periodensystems einen atomaren Anteil an Indium von mindestens 50% enthält.

3. Bauelement nach Anspruch 1 oder 2,
bei dem die Nitrid-Heterostruktur außer der Pufferschicht und der aktiven Schicht mindestens eine weitere Schicht aus III-V-Halbleitermaterial umfaßt, deren Komponente aus der Gruppe III des Periodensystems Indium enthält und deren Komponente aus der Gruppe V des Periodensystems Stickstoff enthält.

4. Bauelement nach einem der Ansprüche 1 bis 3,
bei der die Gitterkonstante jeder indiumhaltigen Schicht zwischen dem Substrat und der aktiven Schicht höchstens um 3% größer ist als die Gitterkonstante einer beliebigen anderen indiumhaltigen Schicht zwischen dem Substrat und der aktiven Schicht.

5. Bauelement nach einem der Ansprüche 1 bis 4,
bei dem das Substrat oder eine darauf aufgewachsene Halbleiterschicht aus einem Material aus der Gruppe von GaN, AlGaN, AlN, Saphir und SiC ist.

6. Bauelement nach einem der Ansprüche 1 bis 5,
bei dem das Substrat oder eine Halbleiterschicht aus einem Material besteht, das eine Gitterkonstante besitzt, die sich um mindestens 2% von der Gitterkonstante der aktiven Schicht unterscheidet.

7. Bauelement nach einem der Ansprüche 1 bis 6,
bei dem jede indiumhaltige Schicht der Nitrid-Heterostruktur eine III-Komponente der Zusammensetzung InₓGa_{y}Al_{1-x-y} mit variablen x und y und mit 0 < x ≤ 1 und 0 ≤ y ≤ 1-x besitzt.
